(19) Europäisches Patentamt / European Patent Office / Office européen des brevets

(11) **EP 2 175 288 A1**

(12) **EUROPEAN PATENT APPLICATION**
published in accordance with Art. 153(4) EPC

(43) Date of publication:
**14.04.2010 Bulletin 2010/15**

(51) Int Cl.:
*G01R 31/30* (2006.01)

(21) Application number: **08805308.7**

(22) Date of filing: **07.07.2008**

(86) International application number:
**PCT/ES2008/000478**

(87) International publication number:
**WO 2009/022038 (19.02.2009 Gazette 2009/08)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **27.07.2007 ES 200702109**

(71) Applicant: **Universidad Politécnica de Madrid 28040 Madrid (ES)**

(72) Inventors:
• **ITUERO HERRERO, Pablo E-28040 Madrid (ES)**
• **AYALA RODRIGO, José Luis E-28040 Madrid (ES)**
• **LOPEZ VALLEJO, Marisa E-28040 Madrid (ES)**

(74) Representative: **Carvajal y Urquijo, Isabel et al Clarke, Modet & Co. Goya 11 28001 Madrid (ES)**

(54) **APPARATUS FOR MEASURING CHIP LEAKAGE CURRENT AND TEMPERATURE**

(57) Device for measuring temperature and leakage current in a chip, which provides an output which linearly varies with the temperature. The device comprises a leakage inverter and an electronic module which digitalizes and linearizes the non-linear output of the leakage inverter. When providing a linear response, the need for storage and data interconnection is reduced, besides the numeric representation thereof is facilitated. The device can be used to measure temperature variations inside a chip and also to measure leakage current variations, which also entails measuring static power variations inside a chip.

Figure 1

EP 2 175 288 A1

## Description

### Technical Field

The invention refers to the technical field of integrated systems, and more specifically to the field of temperature and leakage current measurement inside a chip.

### State of the Art

In an integrated circuit, when a polarized transistor with Metal Oxide Semiconductor (MOS) technology shuts off, a small leakage current flows from its drain to its source and substrate. This happens even when there is no potential difference between the gate and the source. In current technological processes which use transistors with less than 1-micron gate widths, leakage currents no longer have an insignificant value. In the case of circuits with a very large scale integration (VLSI) which use the logics of Complementary Metal Oxide Semiconductor (CMOS), these leakage currents are a constant static current source which entails a permanent static power consumption.

The leakage currents of an MOS transistor can be characterized using the following mathematical model:

$$I_{LEAKS} = I_{S0}e^{\frac{V_{GS}-V_{TH}}{nkT/q}}(1-e^{-\frac{V_{DS}}{kT/q}}) \qquad [1]$$

where kT/q (mV) is the thermal voltage; n is the nonideality factor (dimensionless); $V_{GS}$ and $V_{DS}$ (V) show the potential differences between the gate and the source and between the drain and the source, respectively; $I_{S0}$ (A) is a technological factor given by:

$$I_{S0} = \mu_0 C_{ox}\frac{W}{L}e^{1.8}(kT/q)^2 \qquad [2]$$

where $\mu_0$ (m²/s) is the carriers mobility; $C_{OX}$ (F/m²) is the gate oxide capacitance per unit area; W (m) is the transistor width; and L (m) is the transistor effective length; finally the $V_{TH}$ (V) parameter of the equation [1] represents the threshold voltage of the transistor and is described by the following equation:

$$V_{TH} = V_{TH0} + K(T-T_0) \qquad [3]$$

where $V_{TH0}$ (V) is the threshold voltage at a nominal temperature $T_0$ (°K) and K (V/°K) is the temperature coefficient of the threshold voltage.

The leakage currents can significantly vary from one part of the VLSI chip due to variations in the manufacturing process. Knowledge of these variations can help designers reduce the effects of leakage currents where necessary. It would also help to detect errors and tolerances during the manufacturing process.

In the last few years, power density of integrated circuits and specially of processing systems has increased outstandingly. This growth will become more noticeable in the future, since transistor sizes and frequencies of operation vary more rapidly than supply voltage.

The growth of power density involves a chip temperature increase which, if not controlled, can cause serious problems. It is therefore interesting, from the point of view of design, test and operation of a VLSI chip, to obtain a profile of the temperature variations produced inside a wafer during its operation. With this profile, it would be possible to identify, for example, excessive temperature increases at specific areas ("hot spots").

In the patent document US 2004/0263192 A1, it is proposed a method and device to measure variations inside the wafer of the leakage current and/or in temperature through the use of a leakage inverter or a leakage ring oscillator.

In this document, the concept of a leakage inverter is presented as a device comprising:

- an n-type device and a p-type device which form a path between two power voltages interconnecting through the same terminal, and
- an output node connected to the terminal in common between the two devices, which during the use of the device, provides a signal, the commutation time of which in a single direction is directly proportional to the leakage current of one of the devices p and n.

The concept of a leakage ring oscillator is also presented as a device which provides an oscillating signal at its output, and which comprises a ring oscillator which includes:

- at least one leakage inverter which provides an output signal, the commutation time of which in a single direction is directly proportional to the leakage current of a device of the first leakage inverter.
- one or more static stages.

On the other hand, in scientific literature there are plenty of documents describing electronic modules which carry out the logarithm operation. The creation of a logarithmic counter has also been object of several scientific publications and patents.

## Detailed description of the invention

The present invention refers to a device integrated into a chip which measures temperature or leakage current variations and which provides a signal, the transference function of which realizes an approximation of a linear tendency with temperature variations.

Taking into account the equations [1-3] and supposing that $V_{DS} \gg kT/q$, the relation between the leakage current and temperature can be established in the following way:

$$I_{LEAKS}(T) = K_1 T^2 e^{\frac{K_2}{T}} \qquad [4]$$

therefore, for a given temperature $T_A$, the commutation time of a leakage inverter can be established as the discharge time of a capacitor capacitance C through a current source with an intensity $I_{LEAKS}(T_A)$, when there is a voltage variation $\Delta V$, that is:

$$t_{con}(T_A) = \frac{C \cdot \Delta V}{I_{LEAKS}(T_A)} = \frac{C \cdot \Delta V}{K_1} \frac{e^{\frac{K_2}{T_A}}}{T_A^2} \qquad [5]$$

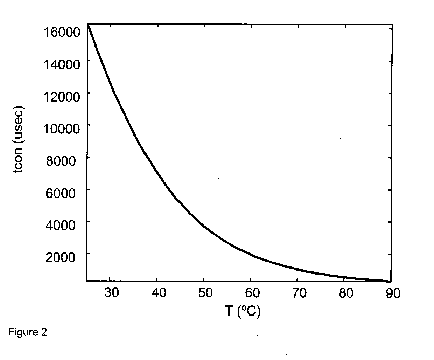

This expression establishes a complex relation between the magnitude provided by the leakage inverter or leakage ring oscillator, and the temperature, figure 2 shows this relation. This expression is also valid for the oscillation period of a leakage ring oscillator which will be directly proportional to the commutation time of one of its leakage inverters.

There are several reasons for searching a linear output in the transference function of a sensor. Particularly, the linear output allows a homogeneous data treatment, facilitating their later processing. That is to say, a homogeneous sampling of the output values of the function is enough, without needing complex adaptive systems which would increase the sample frequency in areas of the function where there is a larger set of output representative values. This facilitates a high degree of compatibility with data control and access systems.

On the other hand, the numeric representation of data is also improved by the linearity of the sensor output. This linear output enables to reduce the number of bits associated to each numerical data and the use of fixed point encoding, as all operands have the same precision. The reduction of the number of bits also entails a reduction of the number of interconnections to transmit data and, therefore, a reduction of power consumption. Besides, if the data are to be stored, the reduction of the number of bits also implies a reduction of the storage requirements.

Finally, if the sensor output is enabled to be feedbacked to any transduction device, if it has a linear input signal, it will offer an optimum response and a wide operation margin.

Therefore, it would be desirable for the sensor to obtain a linear transfer function, or as close to linearity as possible. To that end, the present invention refers to a device comprising:

- a leakage inverter providing a signal, the commutation time of which $t_{con}$, in a single direction is directly proportional to the leakage current of one of the devices p and n forming it; and
- an electronic module which digitalizes $t_{con}$, or a time proportional to it, and which applies to a mathematical transformation producing a linear transference function of the time digitalized with the temperature.

The digitalization of $t_{con}$ can be carried out through a counter which counts the number of clock cycles of $t_{con}$.

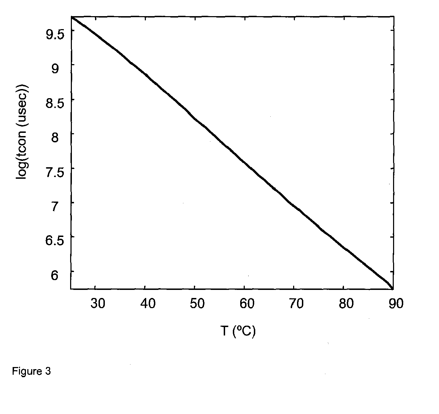

Under certain values of the constants K1 and K2, given by the technology which is to be used in the chip manufacture, the logarithm operation applied to $t_{con}$ represents a very close approximation to a linear transfer function in the temperature interval which an electronic circuit operates. Figure 3 shows the relation between the $t_{con}$ logarithm and the temperature showing a high level of linearity.

The logarithm operation can be carried out on the digitalized output of the counter through an electronic module which calculates the logarithm. It can also be carried out with a logarithmic counter, which calculates the logarithm of the count while it is carried out, thus obtaining only one module instead of two independent modules.

The device of the present invention can be used to measure leakage currents since the relation between $t_{con}$ and the leakage currents is well known. This implies that it can be used to measure the static power consumption, since this consumption has also a well-known relation with the leakage current.

On the other hand, the device of the present invention can be used to measure temperature variations, since the relation between $t_{con}$ and the temperature is also well known.

## Brief description of the drawings/figures

Figure 1 shows an embodiment of the invention. The p-type device (1) and the n-type device (2) form a leakage inverter, the output terminal of which is connected to the capacitor $C_L$ (3) and the inverter (4). After a buffer (5), a logarithmic counter (6) receives the signal which will enable to measure the commutation time of the leakage inverter, and to that end it uses a clock signal (7) and a control signal (8). The input signal (9) activates or deactivates the p-type device. The output signal (10) provides the logarithmic counter count and, therefore, the circuit output.

Figure 2 shows the commutation time transfer function of a leakage inverter with the temperature. The figure has been obtained through computer simulation of a real circuit.

Figure 3 shows the commutation time transfer function of a leakage inverter with the temperature when the logarithm operation has been applied. The figure has been obtained through computer simulation of a real circuit.

## Embodiment of the invention

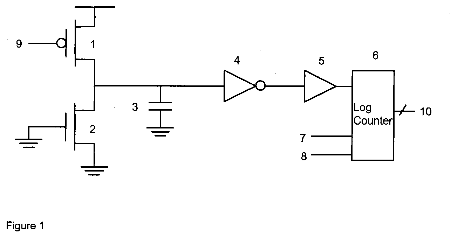

The present invention is illustrated by means of the electronic circuit of figure 1, which does not intend to limit its scope.

Since the device through which the leakage of the leakage inverter are to occur is exclusively the n-type device (2), the gate width will have to be calculated in such a way that the leakage current value of the p-type device (1) can be reduced from the leakage current of the n-type device (2).

When the input signal (9) activates the p-type device (1), the capacitor $C_L$ (3) is charged. When the input signal (9) deactivates the p-type device (1), the output terminal of the leakage inverter is floating and the capacitor $C_L$ (3) begins to discharge through the n-type device (2). Besides, in the moment the input signal (9) deactivates the p-type device (1), the control signal (8) activates the logarithmic counter and its count begins. When, due to the discharge process, the terminal voltage of the capacitor $C_L$ (3) is lower than the inverter (4), the logarithmic counter receives a pulse at its input and stops the count. The count of the logarithmic counter provides the output of the circuit (10).

The following parameters are circuit parameters to carry out an embodiment:

- Manufacturing Technology: CMOS 0,35 $\mu$m
- p-type device (1): W = 0.8 $\mu$m y L = 0.35 $\mu$m
- n-type device (1): W = 60 $\mu$m y L = 0.35 $\mu$m
- Capacitance of capacitor $C_L$ (3): 100 fF
- Clock Frequency (7): 300 KHz

## Claims

1. Device for measuring temperature and leakage current in a chip **characterized in that** it comprises a leakage inverter, which provides a signal, the commutation time of which ,tcon, in a single direction is directly proportional to the leakage current of one of the devices p and n forming it; and one or more electronic modules which digitalize tcon or a time proportional to it, and which apply a mathematical transformation which produces a linear transfer function of the time digitalized with the temperature.

2. Device for measuring temperature and leakage current in a chip, according to claim 1, **characterized in that** for the digitalization it uses a counter which counts the number of clock cycles of tcon or a time proportional to it; and which for the mathematical transformation which produces a linear transfer function of the time digitalized with the temperature an electronic module is used which carries out the logarithm operation on the counter output.

3. Device for measuring temperature and leakage current in a chip, according to claim 1, **characterized in that** a single electronic module digitalizes and linearizes, module which consists of a logarithmic counter which carries out a logarithmic count on tcon or a time proportional to it.

Figure 1

Figure 2

Figure 3

**EP 2 175 288 A1**

# INTERNATIONAL SEARCH REPORT

| | |
|---|---|
| International application No. | |
| PCT/ ES 2008/000478 | |

**A. CLASSIFICATION OF SUBJECT MATTER**

***G01R 31/30*** (2006.01)

According to International Patent Classification (IPC) or to both national classification and IPC

**B. FIELDS SEARCHED**

Minimum documentation searched (classification system followed by classification symbols)

G01R31730, G01R31/28.

Documentation searched other than minimum documentation to the extent that such documents are included in the fields searched

Electronic data base consulted during the international search (name of data base and, where practicable, search terms used)

INVENES, EPODOC, WPI, NPL, XPESP, XPAIP, XPI3E, INSPEC.

**C. DOCUMENTS CONSIDERED TO BE RELEVANT**

| Category* | Citation of document, with indication, where appropriate, of the relevant passages | Relevant to claim No. |
|---|---|---|
| A | US 6882172 B1 (SUZUKI et al.) 19.04.2005, the whole document. | 1-3 |
| A | US 2004263192 A1 (PERSUN et al.) 30.12.2004, the whole document. | 1-3 |

☐ Further documents are listed in the continuation of Box C.   ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance. | | |
| "E" | earlier document but published on or after the international filing date | | |
| "L" | document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" | document referring to an oral disclosure use, exhibition, or other means | "Y" | document of particular relevance; the claimed invention cannot be considered to involve an inventive step when the document is combined with one or more other documents , such combination being obvious to a person skilled in the art |
| "P" | document published prior to the international filing date but later than the priority date claimed | | |
| | | "&" | document member of the same patent family |

| Date of the actual completion of the international search | Date of mailing of the international search report |
|---|---|
| 21.November.2008         (21.11.2008) | **(25/11/2008)** |
| Name and mailing address of the ISA/ O.E.P.M. | Authorized officer |
| Paseo de la Castellana, 75 28071 Madrid, España. | J. Botella Maldonado |
| Facsimile No.   34 91 3495304 | Telephone No. +34 91 349 53 82 |

Form PCT/ISA/210 (second sheet) (July 2008)

## INTERNATIONAL SEARCH REPORT

Information on patent family members

| International application No. |
|---|
| PCT/ ES 2008/000478 |

| Patent document cited in the search report | Publication date | Patent family member(s) | Publication date |
|---|---|---|---|
| US 6882172 B | 19.04.2005 | US 6885210 B | 26.04.2005 |
| | | US 2005212543 A | 29.09.2005 |
| | | US 7126365 B | 24.10.2006 |
| | | US 2005212547 A | 29.09.2005 |
| | | US 7212022 B | 01.05.2007 |
| | | US 7038483 B | 02.05.2006 |
| | | US 7112978 B | 26.09.2006 |
| | | US 7180322 B | 20.02.2007 |
| | | US 7235998 B | 26.06.2007 |
| | | US 7315178 B | 01.01.2008 |
| | | US 7336092 B | 26.02.2008 |
| | | US 7336090 B | 26.02.2008 |
| | | US 2008106295 A | 08.05.2008 |
| US 2004263192 A | 30.12.2004 | US 7193427 B | 20.03.2007 |
| | | US 2004263200 A | 30.12.2004 |

Form PCT/ISA/210 (patent family annex) (July 2008)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040263192 A1